Europäisches Patentamt

European Patent Office

Office européen des brevets

(19)

(11) **EP 0 488 456 B1**

(12) **EUROPÄISCHE PATENTSCHRIFT**

(45) Veröffentlichungstag und Bekanntmachung des Hinweises auf die Patenterteilung:
**02.04.1997 Patentblatt 1997/14**

(51) Int Cl.$^6$: **H04L 25/30**, H03M 13/00

(21) Anmeldenummer: **91203054.1**

(22) Anmeldetag: **22.11.1991**

(54) **Maximalwahrscheinlichkeitsempfänger**

Maximum likelihood receiver

Récepteur à maximum de vraisemblance

(84) Benannte Vertragsstaaten:
**DE ES FR GB IT**

(30) Priorität: **30.11.1990 DE 4038251**

(43) Veröffentlichungstag der Anmeldung:
**03.06.1992 Patentblatt 1992/23**

(73) Patentinhaber:
• **Philips Patentverwaltung GmbH**
**22335 Hamburg (DE)**
Benannte Vertragsstaaten:
**DE**
• **Philips Electronics N.V.**
**5621 BA Eindhoven (NL)**
Benannte Vertragsstaaten:
**ES FR GB IT**

(72) Erfinder: **Baier, Alfred, Dr.**
**W-8501 Eckental (DE)**

(74) Vertreter: **Volmer, Georg, Dipl.-Ing.**
**Philips Patentverwaltung GmbH,**
**Röntgenstrasse 24**
**22335 Hamburg (DE)**

(56) Entgegenhaltungen:
EP-A- 0 127 984       EP-A- 0 391 354
DE-A- 3 911 999

• PROCEEDINGS OF THE 14TH ALLERTON CONFERENCE ON CIRCUIT AND SYSTEM THEORY, September 1976, pages 695-703; J. CONAN / D. HACCOUN: 'Reduced-State Viterbi Decoding of Convolutional Codes'

• IEEE TRANSACTIONS ON COMMUNICATIONS, Bd. 22, Nr. 5, Mai 1974, New York, US, SS. 624-636; G. UNGERBOECK: 'Adaptive Maximum-Likelihood Receiver for Carrier-Modulated Data-Transmission Systems'

• IEEE TRANSACTIONS ON INFORMATION THEORY, Bd. 36, Nr. 7, Januar 1988, New York, US, SS. 13-20; M.V. EYUBOGLU / S.U.H. QURESHI: 'Reduced-State Sequence Estimation with Set Partitioning and Decision Feedback'

• IEEE JOURNAL ON SELECTED AREAS IN COMMUNICATION, Bd. 7, Nr. 6, August 1989, New York, US, SS. 989-995, XP48622; M.V. EYUBOGLU / S.U.H. QURESHI: 'Reduced- State Sequence Estimation for Coded Modulation on Intersymbol Interference Channels'

• IEEE TRANSACTIONS ON COMMUNICATIONS, Bd. 29, Nr. 9, September 1981, New York, US, SS. 1399-1401; C.M. RADER: 'Memory Management in a Viterbi Decoder'

• PROCEEDINGS OF THE IEEE, Bd. 61, Nr. 3, März 1973, New York, US, SS. 268-277; G.D. FORNEY: 'The Viterbi-Algorithm'

• J.G. PROAKIS: 'Digital Communications, 2nd Edition' 1989, MCGRAW-HILL, New York, US; SS. 610-627

• IEEE GLOBAL TELECOMMUNICATIONS CONFERENCE & EXHIBITION GLOBECOM '90, 02.-05.12.1990, San Diego, US, vol. 3, pages 1679-1684, IEEE, New York, US; XP-218858; W. KOCH / A. BAIER: 'Optimun and Sub-Optimun Detection by Time-Varying Intersymbol Interference'

**Beschreibung**

Die Erfindung betrifft einen Empfänger für ein digitales Übertragungssystem mit einem Übertragungskanal mit einer Gedächtnistiefe n mit einem analogen Signalverarbeitungsteil, mit einem Analog-/Digitalwandler und mit einem Entzerrer mit einem digitalen Signalverarbeitungsteil mit einer Register aufweisenden Speichereinrichtung zur Speicherung von Zustandsübergängen.

Derartige Empfänger werden beispielsweise für das künftige paneuropäische Mobilfunksystem (GSM-System) benötigt. Bei diesem Mobilfunksystem werden Sprachsignale in digitalisierter Form zusammen mit anderen digitalen Signalen in einem Zeit-Vielfach-Zugriffs-Verfahren übertragen. Von einem Sender des Mobilfunksystems werden diese Daten mittels einer geeigneten Modulation ausgesandt. Durch Reflektionen und Mehrwegeausbreitung auf dem Übertragungsweg erreicht das ausgesendete Signal den Empfänger in mehreren überlagerten Signalanteilen mit unterschiedlichen Laufzeiten und Phasenverschiebungen. Das vom Sender gesendete Signal wird hierdurch verzerrt. Diese Verzerrungen bewirken, daß die im empfangenen Signal enthaltenen Binärzeichen durch vorangegangene Binärzeichen beeinflußt werden (Nachbarzeichenstörungen). Zwischen Sender und Empfänger liegt ein Übertragungskanal mit einer Gedächtnistiefe n, wobei n eine ganze Zahl ist und die Anzahl von interferierenden Nachbarzeichen angibt. Um den ursprünglichen Dateninhalt des Signales zurückzugewinnen, ist es erforderlich, das empfangene Signal zu entzerren.

Aus DE-A 39 11 999 ist ein Empfänger für ein digitales Übertragungssystem der eingangs genannten Art bekannt. Der Empfänger weist einen Entzerrer zum Bilden von binären Schätzwerten aus einer Folge von Abtastwerten eines Signals auf. Jeder Abtastwert ist einem ausgesendeten Binärzeichen mit dem Binärwert Null oder Eins zeitlich zuordenbar und ist abhängig von diesen Binärzeichen sowie von n unmittelbar diesem Binärzeichen vorangegangenen Binärzeichen. Die Entzerrung erfolgt dabei mit Hilfe des sogenannten Viterbi-Algorithmus. Dabei werden jedem Abtastwert $2^n$ Zustände und jeweils für den Übergang von einem Zustand auf einen zeitlich nachfolgenden Zustand eine Maßzahl für die Wahrscheinlichkeit des Zustandsübergangs zugeordnet. Durch Aneinanderreihung von Zustandsübergängen werden Pfade gebildet, wobei aus allen Maßzahlen eines Pfades eine Gesamtmaßzahl gebildet wird. Von allen auf einen Zustand führenden Pfaden wird jeweils nur der mit der kleinsten Gesamtmaßzahl betrachtet. Dabei werden durch einen Zustandsübergang von einem durch die Binärzeichen $b_{i-1}...b_{i-n}$ bestimmten Zustandsübergang zu einem diskreten Zeitpunkt i mit einem Binärzeichen $b_{i-n} = 0$ (= Null-Übergang) auf einen nachfolgenden durch die Binärzeichen $b_i...b_{i-n+1}$ bestimmten Zustand zu einem Zeitpunkt i+1 sogenannte Null-Pfade und durch einen

Binärwert $b_{i-n} = 1$ (= Eins-Übergang) sogenannte Eins-Pfade bestimmt. Von den Gesamtmaßzahlen aller möglichen Null-Pfade und von allen möglichen Gesamtmaßzahlen aller Eins-Pfades, wird jeweils die kleinste Gesamtmaßzahl ausgewählt. Der durch die Bitfolge $b_i,...b_{i-n}$ für $b_{i-n} = 0$ bzw. $b_{i-n} = 1$ definierte Pfad mit der kleinsten Gesamtmaßzahl unter allen $2^n$ möglichen Null- bzw. Eins-Pfaden kennzeichnet den Null- bzw. Eins-Minimalpfad. Die Binärzahl, d.h. Null oder Eins, die der kleinsten der beiden ausgewählten Gesamtmaßzahlen zugeordnet ist, ergibt den Schätzwert, wobei aus den beiden ausgewählten Gesamtmaßzahlen eine Zuverlässigkeitsinformation für diesen Schätzwert gebildet wird. Die Zuverlässigkeitsinformation wird in einem dem Entzerrer nachgeschalteten Decodierer ausgewertet. Der Realisierungsaufwand des Entzerrers ist in erster Näherung proportional zur Zustandszahl $2^n$, d.h. er steigt expotentiell mit der Gedächtnistiefe n des Übertragungskanals.

Der Erfindung liegt die Aufgabe zugrunde, einen Empfänger der eingangs genannten Art anzugeben, der einen verringerten Realisierungsaufwand aufweist.

Diese Aufgabe wird bei einem Empfänger der eingangs genannten Art dadurch gelöst, daß die Register der Speichereinrichtung jeweils $2^{n'}$ Speicherplätze aufweisen, mit $1 \leq n' < n$, daß die Speichereinrichtung ein Gedächtnispfadregister aufweist, in dem zu jedem diskreten Zeitpunkt ab einem jeweils ersten zeitlich zurückliegenden Binärzeichen für $2^{n'}$- Zustände mindestens n zeitlich zurückliegende Binärzeichen gespeichert werden.

Ein vom Empfänger empfangenes Signal weist wegen der Überlagerung von Nachbarzeichen entsprechend der Gedächtnistiefe n des Übertragungskanals einen analogen Signalverlauf auf. Im analogen Signalverarbeitungsteil erfolgt daher zunächst eine Abtastung des empfangenen Signals. Die so erhaltenen Abtastwerte werden durch den Analog-/Digitalwandler gewandelt und vom Entzerrer weiterverarbeitet. Der Entzerrer des Empfängers beruht dabei auf einem reduzierten Zustandsmodell mit $2^{n'}$ Zuständen, wobei $1 \leq n' < n$ ist. Bei dem Entzerrer mit reduziertem Zustandsmodell sind nur noch n' Binärzeichen direkt durch einen Zustandsübergang bestimmt. Die restlichen n-n' Binärzeichen gehen aus dem zum jeweiligen Zustand führenden Gedächtnispfad hervor, der im Gedächtnispfadregister gespeichert ist. Dies hat den Vorteil, daß gegenüber einem Entzerrer, der alle $2^n$ Zustände berücksichtigt, lediglich $2^{n'}$ Zustände zu jedem Abtastzeitpunkt abzuarbeiten sind. Hierdurch wird in grober Näherung eine Aufwandsreduzierung um den Faktor $2^n/2^{n'}$ erzielt.

Eine aufwandsreduzierte Schätzwertbildung für ein Binärzeichen ergibt sich dadurch, daß der Entzerrer eine Steuer- und Rechenlogik aufweist, die aus n'+1 einen Zustandsübergang kennzeichnenden in der Speichereinrichtung gespeicherten Binärzeichen und aus den n' Binärzeichen des Gedächtnispfadregisters Maßzahlen für diesen Zustandsübergang bildet, die aus der Bitfolge aller $2^{n'}$ möglichen Null- bzw. Eins-Pfade einen Null- bzw. Eins-Minimalpfad und zugeordnete Gesamtmaßzahlen bildet, die entscheidet, daß der Binärwert, der der kleinsten der beiden berücksichtigten Gesamtmaßzahlen zugeordnet ist, einen Schätzwert für das Binärzeichen $b_{i-n'}$ ergibt und die aus den beiden berücksichtigten Gesamtmaßzahlen eine Zuverlässigkeitsinformation für diesen Schätzwert bildet. Dabei übernimmt die Steuer- und Rechenlogik die gesamte Ablaufsteuerung, die Bildung der Maßzahlen und der Gesamtmaßzahlen sowie die Durchführung der auf dem Viterbi-Verfahren basierenden Entzerrung, wie dies beispielsweise in DE-A 39 11 999 beschrieben ist.

Bei einer Ausgestaltungsform weist das Gedächtnispfadregister eine Speichertiefe von M zeitlich zurückliegenden Binärzeichen auf, mit $M \geq n$ und es wird zum Zeitpunkt i für das Binärzeichen $b_{i-N}$ mit $n' < N \leq M$ ein Schätzwert dem Null--Minimalpfad entnommen, wenn die Gesamtmaßzahl des Null--Minimalpfades kleiner als die Gesamtmaßzahl des Eins-Minimalpfades ist, anderenfalls dem Eins-Minimalpfad, wobei durch Verzögerung der Zuverlässigkeitsinformation um N-n' Zeiteinheiten eine zeitrichtige Zuordnung des Schätzwertes des Binärzeichen $b_{i-N}$ zur Zuverlässigkeitsinformation des dem Binärzeichen $b_{i-n'}$ zugeordneten Schätzwertes erfolgt. Die aus weiter zurückliegenden Speicherpositionen des Gedächtnispfades gewonnen Schätzwerte weisen eine höhere Zuverlässigkeit gegenüber den aus einem "kürzeren" Gedächtnispfadregister gewonnenen Schätzwerten auf.

Bei einer weiteren Ausgestaltungsform weist das Gedächtnispfadregister eine Speichertiefe von M zeitlich zurückliegenden Binärzeichen auf, mit $M \geq n$, wobei zum Zeitpunkt i für das Binärzeichen $b_{i-N}$ mit $n' < N \leq M$ eine Zuverlässigkeitsinformation gebildet wird und wobei diese Zuverlässigkeitsinformation durch einen vorgebbaren Ersatzwert ersetzt wird, wenn zum Zeitpunkt i entweder nur Null- oder Eins-Pfade existieren. Hierdurch wird erreicht, daß der Entzerrer in den Fällen, in denen für das Binärzeichen $b_{i-N}$ keine exakte Zuverlässigkeitsinformation ableitbar ist, mit einem geeigneten Ersatzwert weiterarbeitet.

Bei einer Ausgestaltungsform wird die Zuverlässigkeitsinformation durch das Verhältnis der den beiden ausgewählten Pfaden entsprechenden Wahrscheinlichkeitswerten gebildet. Durch das Verhältnis dieser beiden Wahrscheinlichkeitswerte wird dann ausgedrückt, um wieviele Male ein Schätzwert wahrscheinlicher als der Komplementärwert zu diesem Schätzwert ist.

Bei einer weiteren Ausgestaltungsform wird als Metrik einer Maßzahl die quadratische Distanz der Wahrscheinlichkeit des Übergangs zwischen zwei Zuständen verwendet und zur Bildung der Gesamtmetrik einer Gesamtmaßzahl die ermittelte Metrik für einen Zustandsübergang zur bisherig ermittelten Gesamtmetrik addiert. Dabei wird die Möglichkeit ausgenutzt, daß anstelle der Maßzahlen sogenannte Metriken verwendet werden können, die sich aus dem negativen Logarithmus der jeweiligen Maßzahl ergeben. Dies hat den Vorteil, daß zur Errechnung einer Verbundwahrscheinlichkeit, bei der die einzelnen Maßzahlen zu multiplizieren sind, nun die Metriken nur noch addiert werden müssen.

Bei einer Ausgestaltungsform wird die Gesamtmetrik der Null-Pfade von der Gesamtmetrik der Eins-Pfade subtrahiert, wobei das Vorzeichen der Differenz den Schätzwert und der Absolutbetrag der Differenz die dem Schätzwert zugeordnete Zuverlässigkeitsinformation ergibt. Ein positives Vorzeichen gibt dabei an, daß Eins als Schätzwert wahrscheinlicher ist als Null.

Bei einer Ausgestaltungsform wird die Zuverlässigkeitsinformation mit einer von einer ermittelten Störleistung hängigen Größe berichtigt. Mit der so bewerteten lässigkeitsinformation hat man dann die Möglichkeit, bei der Weiterverarbeitung des Empfangssignals bevorzugt diejenigen Datenelemente des Empfangssignals heranzuziehen, die ein Optimum an Sicherheit gegen fehlerhafte Schätzung bilden.

Bei einer Ausgestaltungsform werden zu übertragende Informationen sendeseitig durch einen Faltungscoder in die Binärzeichen umcodiert, wobei empfangsseitig nach dem Entzerrer als Decoder ein Faltungsdecoder angeordnet ist, welcher bei der Decodierung neben den geschätzten Binärzeichen auch deren zugeordnete Zuverlässigkeitsinformation verarbeitet. Auf diese Weise erhöht sich die Wahrscheinlichkeit, daß bei der Decodierung auch tatsächlich die gesendete Datenfolge zurückerhalten wird, da der Decoder auch die Informationen enthält, welchen einzelnen Binärzeichen er mehr und welchen er weniger "vertrauen" darf.

Im folgenden wird die Erfindung anhand der in den Figuren dargestellten Ausführungsbeispiele näher erläutert.

Es zeigen:

Fig. 1 ein Blockschaltbild eines digitalen Übertragungssystems.
Fig. 2 bis Fig. 4 Zustandsdiagramme für einen Entzerrer.
Fig. 5 ein weiteres Ausführungsbeispiel eines digitalen Übertragungssystems.

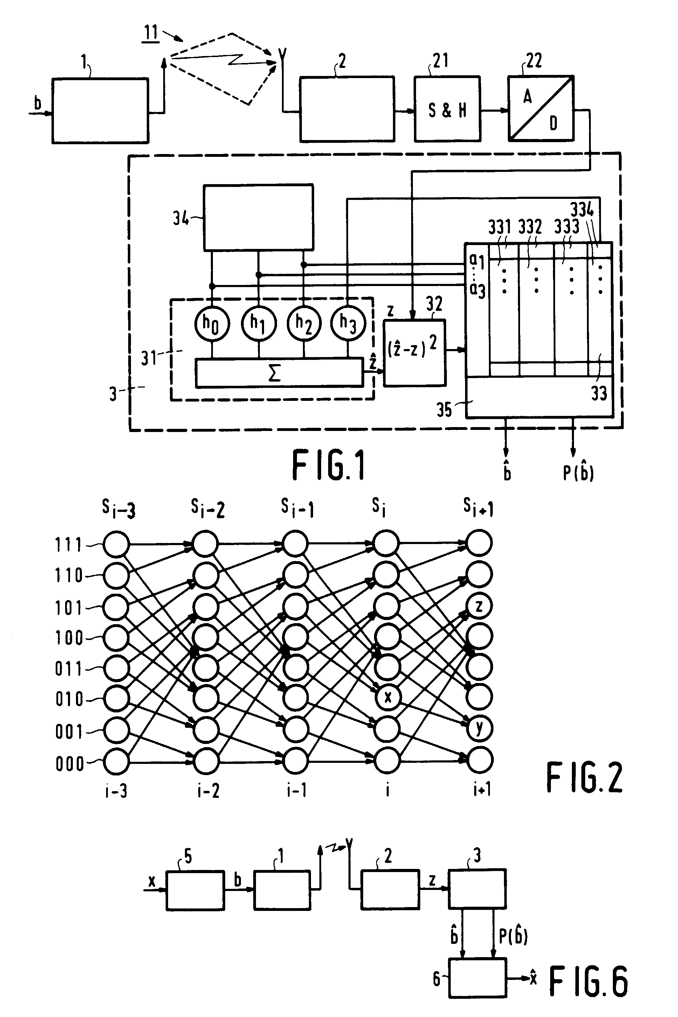

In Figur 1 ist ein Funkübertragungssystem dargestellt, bei dem die zu übertragenden Informationen in Form eines Binärsignals b über einen Sender 1 abgestrahlt werden. Zwischen dem Sender 1 und einem aus einem Signalempfänger 2, einem Abtasthalteglied 21, einem Analog/Digitalumsetzer 22 sowie einem Entzerrer 3 gebildeten Empfänger liegt als Übertragungskanal 11 eine durch einen Pfeil gekennzeichnete Funkübertragungsstrecke. Dem Signalempfänger 2 ist das Abtasthalteglied 21 sowie der Analog/Digitalumsetzer 22 nachgeschaltet. Die Signale am Digitalausgang des Analog/Digitalumsetzers 22 werden dem Entzerrer 3 zugeführt. Der Entzerrer 3 besteht aus einem digitalen Signalverarbeitungsteil mit einem Signalbewerter 32, einer Steuerschaltung 34, einem Transversalfilter 31, einer im folgenden auch als Speicherbaustein bezeichneten Speichereinrich33 sowie einer Steuer- und Rechenlogik 35. Die chereinrichtung 33 weist Register 331, 332, 333 sowie ein Gedächtnispfadregister 334 auf. Die Steuer- und Rechenlogik 35 liefert einen Schätzwert $\hat{b}$ sowie eine Zuverlässigkeitsinformation P ($\hat{b}$) für diesen Schätzwert $\hat{b}$.

Auf der zwischen dem Sender 1 und dem Empfänger 2 liegenden Funkübertragungsstrecke 11 wird das ausgesendete Signal durch Mehrwegeausbreitung in Folge von Reflektionen und durch Überlagerung von Rauschen und sonstigen störenden Signalen verzerrt, wie dies in Figur 1 durch die gestrichelt eingezeichneten Pfeile der Funkübertragungsstrecke angegeben ist. Hierdurch wird ein zu einem diskreten Zeitpunkt i gesendetes Binärzeichen $b_i$ des Binärsignals b durch verspätet eintreffende Signalanteile zuvor gesendeter Binärzeichen $b_{i-1}$, $b_{i-2}$,... überlagert. Diese Überlagerung entspricht einer Signalverzerrung. Dadurch ist das zu einem gesendeten Binärzeichen empfangene Signal nicht mehr eindeutig einem niedrigen oder hohen Pegel zuordenbar. Der Übertragungskanal 11 weist somit eine Gedächtnistiefe n auf, wobei n die Anzahl der interferierenden Nachbarzeichen angibt. Die Gedächtnistiefe n kann auch als Quotient aus der Länge der Kanalimpulsantwort des Übertragungskanals 11 und aus einer Bitdauer des Empfangssignals minus 1 definiert werden, wobei von diesem Ergebnis noch die größte ganze Zahl zu nehmen ist. Das vom Empfänger 2 empfangene Signal weist durch diese Überlagerungen einen analogen Signalverlauf auf, der ohne Entzerrung dem ursprünglich gesendeten Binärwert nicht zuordenbar ist. Das vom Empfänger 2 empfangene Signal wird zunächst mittels des Abtasthaltegliedes 21 zu äquidistanten Zeitpunkten abgetastet. Die so erhaltenen analogen Abtastwerte werden zur weiteren Verarbeitung durch den Analog/Digitalumsetzer 22 in digitale Abtastwerte z umgesetzt.

Der Einfluß bereits gesendeter Binärzeichen ist abhängig von der Laufzeitverzögerung der am Empfänger verzögert eintreffenden Signalanteile. Dabei ist nach einer gewissen Zeit, die von der Charakteristik des Übertragungskanals abhängt, der Einfluß nicht mehr wesentlich und braucht daher bei einer Entzerrung nicht mehr berücksichtigt zu werden. In der Regel wird die Laufzeitverzögerung als Anzahl in der in dieser Zeitspanne ausgesendeten Binärzeichen angegeben. Damit gilt für den Entzerrer 3, daß jeder einem zu einem Zeitpunkt i gesendeten Binärzeichen $b_i$ zuordenbare Abtastwert $z_i$ von dem ihm zuordenbaren Binärzeichen $b_i$ und von n unmittelbar diesem Binärzeichen angegangenen Binärzeichen $b_{i-1}$, $b_{i-2}$,..., $b_{i-n}$ abhängig ist.

Der Entzerrung des Signals z vom Ausgang des Analog/Digitalwandlers 22 liegt ein Kanalmodell zugrunde, das den dispersiven Übertragungskanal 11 des Funkübertragungssystems näherungsweise durch ein lineares endliches Transversalfilter beschreibt. Bei einem derartigen Kanalmodell werden die Übertragungseigenschaften des Übertragungskanals durch Filterkoeffizienten $h_0$...$h_n$ nachgebildet. Auf der Empfangsseite wird daher versucht, genau mit diesem Kanalmodell die auf dem Übertragungsweg auftretenden Verzerrungen durch die gedächtnisbehafteten Linearkombinationen mittels des Transversalfilters 31 nachzubilden. Die Nachbildung des Übertragungsweges wird durch entsprechende Einstellung der Filterkoeffizienten $h_0$,...$h_3$ für n=3 erreicht. Die Filterkoeffizienten $h_0$, ...$h_3$ sind hierbei aus den Abtastwerten einer geschätzten Impulsantwort des Übertragungskanals ableitbar. Hierzu kann beispielsweise eine sogenannte Trainingssequenz verwendet werden, die aus einer sowohl dem Sender 1 als auch dem Empfänger 2 bekannten Binärzeichenfolge besteht. Bei jedem Empfang der Trainingssequenz werden die Filterkoeffizienten $h_0$,...$h_3$ so eingestellt, daß nach Durchlaufen des Transversalfilters 31 der Übertragungskanal mit dem geringsten Fehler nachgebildet wird. Dies ist beispielsweise aus DE 40 01 592 A1 bekannt.

Bei dem in Figur 1 dargestellten Ausführungsbeispiel ist die Schaltungsanordnung zur Bildung der Filterkoeffizienten aus Gründen der Übersichtlichkeit nicht dargestellt. Der in Figur 1 dargestellte Entzerrer 3 beruht auf dem sogenannten Viterbi-Verfahren, wie dies beispielsweise in der europäischen Patentanmeldung EP 0 294 116 A2 beschrieben ist. Das Viterbi-Verfahren als solches ist beispielsweise in dem Aufsatz "The Viterbi Algorithm", G. David Forney jr., Proceedings of the IEEE, Vol. 61, No. 3, March 1973, beschrieben. Dabei wird für eine sogenannte Soft--Desicion-Decodierung für die zu decodierenden Datenelemente einer codierten Datenfolge eine Zuverlässigkeitsinformation für die zu decodierende Datenfolge benötigt. Die Zuverlässigkeitsinformation ist eine Maßzahl, die angibt, mit welcher Wahrscheinlichkeit die zu decodierenden Datenelemente den gesendeten Datenelementen entsprechen. Zur Darstellung des Viterbi-Verfahrens wird in der Regel ein Zustandsdiagramm verwendet, wie dies in den Figuren 2 bis 4 dargestellt ist. Anstelle der Maßzahlen können auch sogenannte Metriken verwendet werden, wobei sich die Metrik aus dem negativen Logarithmus der jeweiligen Maßzahl berechnet. Dies hat unter anderem den Vorteil, daß zur Errechnung einer Verbundwahrscheinlichkeit, bei der die einzelnen Maßzahlen zu multiplizieren sind, die Metriken lediglich noch addiert werden müssen.

Zur Berechnung der Übergangswahrscheinlichkeit von einem Zustand zu einem zeitlich nachfolgenden Zustand werden die einzelnen Binärwerte der Binärzeichen $b_i$,...,$b_{i-n}$ eines Zustands als Eingangsparameter des Transversalfilters 31 verwendet. Der Ausgangswert des Transversalfilters 31 ergibt in erster Näherung unter Vernachlässigung von Störungen durch ein im Eingangssignal enthaltendes Stör- oder Rauschsignal etc. den Wert, den der Abtastwert annehmen müßte, wenn die als Eingangsparameter verwendete Binärzeichenfolge $b_i$,...,$b_{i-n}$ über den Funkübertragungsweg gesen-

det und empfangen wird. Durch Vergleich des Ausgangswertes des Transversalfilters 31 mit dem tatsächlichen Abtastwert kann daher die am wahrscheinlichsten gesendete Binärzeichenfolge gefunden werden.

Allerdings bietet eine große Übergangswahrscheinlichkeit von einem Zustand zu einem zeitlich folgenden Zustand noch keine ausreichende-Gewähr Gewähr für die Richtigkeit dieses Übergangs, da durch kurzzeitige Störungen oder Signalrauschen zufälligerweise ein tatsächlich nicht erfolgter Zustandsübergang als wahrscheinlichster Übergang erscheint. Korrektere Schätzungen der Zustandsübergänge werden durch eine Berücksichtigung des gesamten bisherigen Signalverlaufs in Form einer Wahrscheinlichkeitsbetrachtung aller Zustandsübergänge, die zu einem der $2^n$ Zustände des betrachteten Zeitpunktes führen, erzielt. Der Realisierungsaufwand eines derartigen Entzerrers ist jedoch annähernd proportional zur Zustandsanzahl $2^n$, d.h. er steigt exponentiell mit der Gedächtnistiefe n des Übertragungskanals.

Der in Figur 1 dargestellte Entzerrer 3 hingegen basiert auf einem Zustandsmodell mit $2^{n'}$ Zuständen, mit $1 \leq n' < n$. Bei dem in Figur 1 dargestellten Ausführungsbeispiel ist n=3 und n'=2. Hierdurch ergibt sich eine Reduzierung der Zustandsanzahl $2^{n'}$=4 gegenüber dem Entzerrer mit vollständiger Zustandsanzahl $2^n$=8. Dabei besteht der Unterschied zum Entzerrer mit voller Zustandszahl $2^n$ darin, daß beim Entzerrer mit reduzierter Zustandsanzahl $2^{n'}$ nur noch die n' Binärzeichen $b_i,....,$ $b_{i-n'}$ direkt durch einen Zustandsübergang $S_i'$, $S_{i+1}'$ bestimmt sind. Die restlichen n-n' Binärzeichen $b_{i-n-1},..., b_{i-n}$ gehen aus einem zum jeweiligen Zustand $S_i'$ führenden Gedächtnispfad hervor, der in einem Gedächtnispfadregister 334 des Speicherbausteins 33 gespeichert wird. Im Gegensatz zum Soft-Desicion-Entzerrer mit voller Zustandsanzahl muß daher beim Soft-Desicion-Entzerrer mit reduzierter Zustandsanzahl das Gedächtnispfadregister 334 geführt werden. In diesem werden zu jedem Zeitpunkt i ab dem Binärzeichen $b_{i-1}$ für alle $2^{n'}$-Zustände $S_i'$ mindestens n zeitlich zurückliegende Binärzeichen $b_{i-1}, ..., b_{i-n'}, b_{i-n'-1}, ..., b_{i-n'...}$ gespeichert. Die Binärzeichen $b_{i-1}, ..., b_{i-n'}$ müssen im Gedächtnispfadregister 334 nicht unbedingt gespeichert werden, da sie mit den Zustandsbits des jeweiligen Zustands $S_i'$ identisch sind.

Im Ausführungsbeispiel der Figur 1 wird zur Bildung der Metrik ein Ausgangswert $\hat{z}_i$ des Transversalfilters 31 vom digitalen Abtastwert $z_i$ in einem Signalbewerter 32 subtrahiert und betragsmäßig quadriert. Auf diese Weise wird eine quadratische Distanz gebildet. Dabei ist die Wahrscheinlichkeit, daß der empfangene Abtastwert aus der als Eingangsparameter verwendeten Binärzeichenfolge hervorgegangen ist, um so größer, je kleiner diese quadratische Distanz ist. Wegen der Linearkombination der jeweils n letzten Binärzeichen kann aber immer erst nach Empfang aller n Binärzeichen ein optimaler Schätzwert gebildet werden.

Der dem Abtastwert $z_i$ zugeordnete Schätzwert $\hat{b}_i$

ist zeitlich den Zustandsübergängen von einem Zustand $S_i$, auf die Zustände $S_{i+1}'$ des Zeitpunkts i+1 zugeordnet.

Zur Durchführung des Verfahrens sind in dem in Figur 1 dargestellten Ausführungsbeispiel im Speicherbaustein 33 im folgenden auch als Metrikregister bezeichnete Register 331, 332, 333 sowie das Gedächtnispfadregister 334 vorgesehen. Jedes Register hat $2^{n'}$ Speicherplätze, wobei die drei Bits $a_1...a_3$ zur Adressierung der Spalten dienen, wie dies im folgenden beschrieben ist. Den einzelnen Speicherplätzen der Register ist dabei jeweils eine Adresse $a_1...a_3$ zugeordnet. Dabei ist im ersten Register 331 die einem Zustand zugeordnete Gesamtmetrik gespeichert. Im zweiten Metrikregister 332 wird unter der jeweiligen Adresse $a_1...a_3$ eine neue Gesamtmetrik gespeichert, die sich durch einen Null-Übergang ergeben hat, d.h. sogenannte Null-Pfade, während im dritten Register 333 eine erhaltene Gesamtmetrik gespeichert wird, die sich durch einen Eins-Übergang ergeben hat, d.h. sogenannte Eins-Pfade gespeichert. Dabei werden durch einen Zustandsübergang von einem durch die Binärzeichen $b_{i-1}...b_{i-n}$ bestimmten Zustand $S_i'$ zu einem Zeitpunkt i mit einem Binärzeichen $b_{i-n'}$= 0 (= Null-Übergang) auf einen zeitlich nachfolgend durch die Binärzeichen $b_i... b_{i-n'+1}$ bestimmten Zustand $S_{i+1}$ zu einem Zeitpunkt i+1 sogenannte Null-Pfade und entsprechend mit einem Binärzeichen $b_{i-n'}$ = 1 (= Eins-Übergang) sogenannte Eins-Pfade bestimmt. Im Gedächtnispfadregister 334 werden darüberhinaus mindestens n zeitlich zurückliegende Binärzeichen für alle $2^{n'}$, d.h. bei dem in Figur 1 dargestellten Ausführungsbeispiel für vier Zustände gespeichert. Die Steuerschaltung 34 gibt bei der Ansteuerung eines Speicherplatzes dessen Adresse $a_1...a_3$ gleichzeitig als gangsparameter dem Transversalfilter 31 vor. Der erste Eingangsparameter wird an der Steuerschaltung für jede gebildete Adresse einmal als erste Binärzahl, z.B. 0 vorgegeben. Aus dem auf diese Weise erhaltenen Wert $\hat{z}$ des Transversalfilters 31 und dem Abtastwert z wird in der Bewertungsschaltung 32 die quadratische Distanz $(\hat{z}-z)^2$ gebildet. Aus dieser quadratischen Distanz und der im ersten Metrikregister 331 unter der jeweiligen Adresse gespeicherten Gesamtmetrik wird eine neue Gesamtmetrik gebildet, die im zweiten Metrikregister 332 unter der jeweils eingestellten Adresse gespeichert wird. Auf gleiche Weise wird mit dem ersten Eingangsparameter die zweite Binärzahl, z. B. 1 vorgegeben und es wird die auf diese Weise erhaltene Gesamtmetrik im dritten Metrikregister 333 gespeichert. Nachdem die Steuerschaltung 34 alle Adresskombinationen durchlaufen hat und alle Inhalte des zweiten und dritten Pfadregisters 332, 333 neu berechnet sind, wird aus allen neuen Gesamtmetriken des zweiten und dritten Metrikregisters 332, 333 jeweils der kleinste Wert ausgewählt. Diese beiden Werte werden subtrahiert. Aus dem Vorzeichen der Differenz ergibt sich schließlich der Schätzwert $\hat{b}$ und aus dem Absolutbetrag der Differenz die gewünschte Zuverlässigkeitsinformation $P(\hat{b})$ für das Binärzeichen $b_{i-n'}$. Nachdem der

Schätzwert $\hat{b}$ ermittelt ist, erfolgt nun ein Up-date, das heißt die Umspeicherung der ersten bis dritten Register 331...333 sowie der im dächtnispfadregister 334 gespeicherten Metriken.

Dabei übernimmt die auch als Entzerrerlogik bezeichnete Steuer- und Rechenlogik 35 die gesamte Ablaufsteuerung, die Bildung der Gesamt-Metriken sowie die Durchführung des Viterbi-Algorithmus. Dies erfolgt in einer Weise, wie dies beispielsweise aus der DE-A 39 11 999 bekannt ist. Anschließend wird bis zum Eingang eines neuen Abtastwertes gewartet, und auf die bereits beschriebene Weise der zugehörige neue Schätzwert und die zugehörige Zuverlässigkeitsinformation gebildet.

Somit werden bei dem in Fig. 1 dargestellten Ausführungsbeispiel folgende Schritte durchgeführt:

1. Hole $L_i(b_{i-1},...,b_{i-n'}) = L_i(S_i')$ aus Register 331
2. Hole $(b_{i-n'-1},...,b_{i-n})$ aus Register 334 für den Pfad $(b_{i-1},...,b_{i-n'})$
3. $L_{i+1}(S_i', S_{i+1}') = L_{i+1}(b_i, b_{i-1},..., b_{i-n'}) = L_i(S_i') + |\hat{z}_i - z_i|^2$,
wobei

$$\hat{z}_i = \sum_{v=0}^{n} y_{i-v} \times h_v$$

mit $y_{i-v} \in (+1, -1)$
4. Wenn $b_{i-n'} = 0$, speichere $L_{i+1}(S_i', S_{i+1}')$ in Register 332 unter Adresse $(b_i, b_{i-1},...b_{i-n'+1})$
5. Wenn $b_{i-n'} = 1$, speichere $L_{i+1}(S_i', S_{i+1}')$ in Register 333 unter Adresse $(b_i, b_{i-1},..., b_{i-n'+1})$
6. Suche Minimum der Null-Pfade $L_{i+1}$ aus Register 332
7. Suche Minimum der Eins-Metriken $L_{i+1}$ aus Register 333
8. Bestimme $P(\hat{b}_{i-n'})$ und $\hat{b}_{i-n'}$ aus Minima (6. und 7.)
9. Up-date Register 331 und 334.

Dabei sind mit L die Gesamtmetriken der die jeweiligen Zustandsübergänge kennzeichnenden Pfade bezeichnet.

Das in Figur 2 dargestellte Zustandsdiagramm ist ein Graph mit in vertikaler Richtung aufgetragenen Reihen von jeweils $2^n$ Knoten. Jeder Knoten repräsentiert eine der Kombinationen, die sich aus n Binärzeichen ergeben. Jede vertikale Reihe ist einem bestimmten Abtastzeitpunkt i-3, i-2, i-1, i, i+1 zugeordnet. Die einzelnen, einem Knoten zuordenbaren Binärwerte 000...111 werden als Zustand bezeichnet. Dabei entspricht ein Zustand jeweils einer möglichen Zuordnung der zu einem Zeitpunkt i empfangenen n letzten digitalen Abtastwerte zu einer möglicherweise gesendeten Binärwertfolge. Beim Empfang eines neuen Abtastwertes kann diesem sowohl die Binärzahl 0 oder die Binärzahl 1 zugeordnet werden. Aus einer Binärwertfolge 010 wird durch die Zuordnung des neuesten Abtastwertes zu dem Binärwert 0 die Folge 0010. Da durch den Empfang eines neuen Abtastwertes der jeweils älteste Abtastwert ohne Einfluß auf die Entzerrung wird, wird dieser letzte Binärwert weggelassen. In dem in Figur 2 dargestellten standsdiagramm sind alle möglichen Übergänge durch Pfeile gekennzeichnet. So kennzeichnet der Knoten x einen Zustand der Binärfolge 010 zum Zeitpunkt i. Durch eine 0 gelangt man auf den Knoten y, dem zum Zeitpunkt i+1 der Zustand $S_{i+1} = 001$ zugeordnet ist, durch einen Eins-Übergang gelangt man auf den Knoten z, dem zum Zeitpunkt i+1 der Zustand $S_i = 101$ zugeordnet ist. Durch eine Aneinanderreihung von zusammenhängenden Übergängen erhält man einen Pfad. Dieser Pfad ist gleichbedeutend mit der rekonstruierten Binärfolge $b_i,...$ $b_{i-n}$. Durch das in Figur 2 dargestellte Zustanddiagramm das auf dem aus DE-A 39 11 999 bekannten Zustandsmodell beruht, wird deutlich, daß der Realisierungsaufwand für einen auf einer Zustandsanzahl $2^n$ basierenden Entzerrung hoch ist.

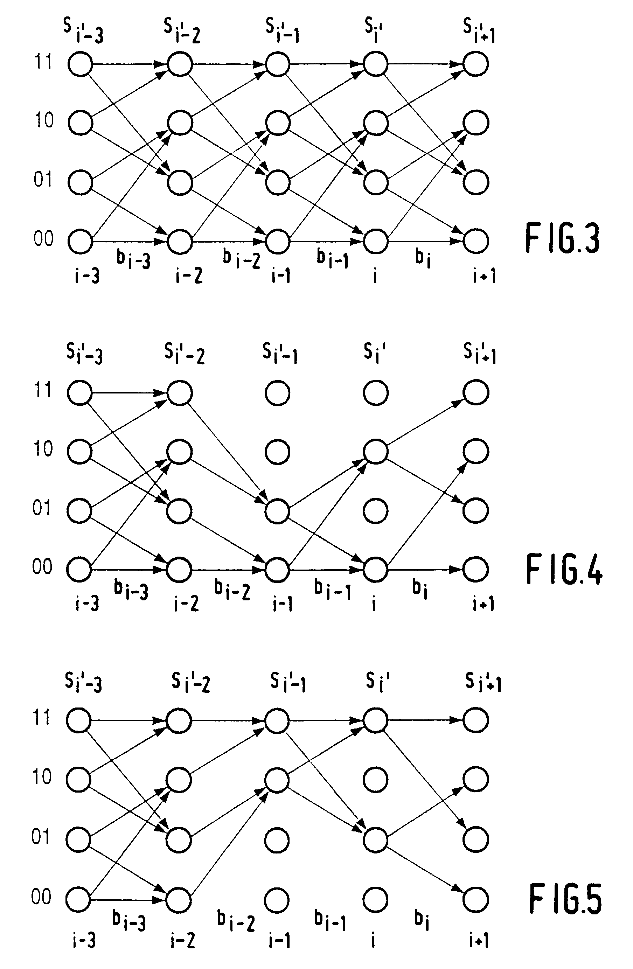

Figur 3 zeigt ein Zustandsdiagramm für den in Figur 1 dargestellten Entzerrer, der auf einem Zustandsmodell mit lediglich $2^{n'}$ Zuständen mit $2^{n'}=4$ basiert. Wird das in Figur 2 dargestellte Zustandsdiagramm dem in Figur 3 angegebenen Zustandsdiagramm gegenübergestellt, so wird die Einsparung an Realisierungsaufwand gegenüber einem Zustandsmodell mit $2^n$ Zuständen deutlich. Dabei sind in dem in Fig. 3 dargestellten Zustandsdiagramm (Zustandstrellis) alle möglichen Pfade gekennzeichnet. Allgemein werden durch einen Zustandsübergang von einem durch die Binärzeichen $b_{i-1}...b_{i-n'}$ bestimmten Zustand $S_i'$ zu einem Zeitpunkt i mit einem Binärzeichen $b_{i-n'} = 0$ (= Nullübergang) auf einen zeitlich nachfolgenden durch die Binärzeichen $b_i...b_{i-n'+1}$ bestimmten Zustand $S_{i+1}'$ zu einem Zeitpunkt i+1 sogenannte Null-Pfade und entsprechend mit einem Binärzeichen $b_{i-n'} = 1$ (= Eins--Übergang) sogenannte Eins-Pfade bestimmt. Bei dem in Fig. 3 dargestellten Zustandstrellis wurde entsprechend den in der Beschreibung zur Fig. 1 bereits verwendeten Beispielen der Beschreibung zur Fig. 1 bereits verwendeten Beispielen n'=2 verwendet. Somit wird bei dem in Fig. 3 dargestellten Zustandstrellis durch die Binärzeichen $b_i$, $b_{i-1}$, $b_{i-2}$ der Zustandsübergang $S_i'$, $S_{i+1}'$ gekennzeichnet. Das den Zustand $S_{i+1}'$ kennzeichnende Binärzeichen $b_{i-3}$ kann zum Zeitpunkt i an der Position i-3 aus dem Gedächtnispfadregister geholt werden.

In Fig. 4 ist ein Zustandsdiagramm dargestellt, bei dem nur noch alle Pfade eingezeichnet sind, bei denen alle Übergänge vom Zeitpunkt i-2 auf den Zeitpunkt i-1 Null--Übergänge waren, d.h. bei denen den Binärzeichen $b_{i-2}$ jeweils die Binärzahl 0 zugeordnet war. Dies entspricht den Null-Pfaden für einen Zustandsübergang $S_i'$, $S_{i+1}'$. Für die Werte des Ausführungsbeispiels n = 3, n' = 2 werden dann die Maßzahlen aus $2^{n'} = 4$ Zuständen 11, 10, 01, 00 gewonnen. Dabei sind nur die n'+1 = 3 Binärzeichen $b_i$, $b_{i-1}$, $b_{i-2}$ direkt durch den Zustandsübergang $S_i'$, $S_{i+1}'$ bestimmt, während das restliche n-n' = 1 Binärzeichen $b_{i-3}$ aus dem zum Zustand $S_i'$ führenden

Gedächtnispfad hervorgeht. Aus diesem Grund muß im Gegensatz zum sogenannten Soft-Desicion-Entzerrer mit voller Zustandsanzahl explizit ein Gedächtnispfadregister geführt werden, das zu jedem Zustand i für alle $2^{n'}$ Zustände den Gedächtnispfad $b_{i-1}, \ldots b_{i-n'}, b_{i-n'-1}, \ldots b_{i-n}, \ldots$) in einer Länge von mindestens n Binärzeichen gerechnet ab dem Binärzeichen $b_{i-1}$ speichert. Dabei dürfen die Binärzeichen $b_{i-1}, \ldots b_{i-n}$ auch weggelassen werden, das sie ja mit den Binärzeichen des jeweiligen Zustands $S_i'$ identisch sind.

In Fig. 5 ist ein Zustandstrellis dargestellt, bei dem nur noch alle Eins-Pfade für einen Zustandsübergang $S_i'$, $S_{i+1}'$ eingezeichnet sind. Dabei ist dem Binärzeichen $b_{i-2}$ jeweils die Binärzahl 1 zugeordnet. Zur Bildung des Schätzwertes und der Zuverlässigkeitsinformation wird aus allen Gesamtmetriken der Zustände, die sich durch einen Null-Übergang und aus allen Gesamtmetriken, die sich aus einem Eins--Übergang ergeben haben, jeweils die kleinste Gesamtmetrik ermittelt. D.h. es wird aus den Zustandsdiagrammen der Fig. 4 und der Fig. 5 jeweils der Pfad mit der kleinsten Gesamtmetrik ausgewählt. Diese Pfade bilden dann den Null- bzw. Eins-Minimalpfad. Jede der beiden ausgewählten Minimal-Gesamtmetriken gibt für sich die Wahrscheinlichkeit wieder, mit der der jeweils ausgewählte Pfad im günstigen Fall dem Schätzwert $b_{i-n'} = 0$ bzw. dem Schätzwert $b_{i-n'} = 1$ zugeordnet werden kann. Diese Wahrscheinlichkeitswerte lassen sich aus den Gesamtmetriken berechnen. Im letzten Schritt werden die beiden für jeden Zustand $S_{i+1}$ vorliegenden Gesamtmaßzahlen miteinander verglichen und die jeweils kleinere Gesamtmaßzahl als neue Gesamtmaßzahl dem jeweiligen Zustand $S_{i+1}$ zugeordnet. Durch inverse Metriken ist es auch möglich, anstelle von Minima auch Maxima zu bilden.

In Figur 6 ist ein weiteres Ausführungsbeispiel eines digitalen Übertragungssystems dargestellt. Dabei wird eine zu übertragende Information x zunächst einem Faltungscodierer 5 zugeführt. Der Faltungscodierer 5 liefert ein Binärsignal b, welches mittels eines Senders 1 über einen dispersiven Übertragungskanal übertragen wird. Auf der Empfangsseite ist ein Empfänger 2 angeordnet, der ein Abtastsignal z liefert. Dieses Abtastsignal z wird einem Entzerrer 3 zugeführt. Der Entzerrer liefert Schätzwerte $\hat{b}$ sowie eine zugehörige Zuverlässigkeitsinformation P $(\hat{b})$. Die Schätzwerte sowie die Zuverlässigkeitsinformation werden einem Decodierer 6 zugeführt, der hieraus eine Folge $\hat{x}$ decodiert. Dabei wird zur Decodierung ein nach dem Viterbi-Verfahren arbeitender Decodierer verwendet.

Bei der Viterbi-Decodierung wird die empfangene codierte Signalfolge jeweils mit allen gültigen Code-Folgen, die der Coder 5 erzeugt haben könnte, verglichen. Dabei wird für den Viterbi-Decoder die Anzahl der Bits, in denen die entzerrte Datenfolge sich von den einzelnen Codeelementen des Codevorrats unterscheidet, verwendet. Durch Multiplizieren einer auf diese Weise erhaltenen Metrik mit der verlässigkeitsinformation erhält man eine Bewertung einer zu decodierenden Datenfolge. Auf diese Weise erhöht sich die Wahrscheinlichkeit, daß bei der Decodierung auch tatsächlich die gesendete Datenfolge zurückerhalten wird. Der Decodierer 6 verwendet dabei nicht nur die Signalredundanz zur Decodierung, sondern auch Informationen, welchen einzelnen Binärzeichen der zu decodierenden Datenfolge er mehr oder weniger "vertrauen" darf.

## Patentansprüche

1. Empfänger für ein digitales Übertragungssystem (1, 2, 21, 22, 3) mit einem Übertragungskanal (11) mit einer Gedächtnistiefe n, mit einem analogen Signalverarbeitungsteil (2, 21), mit einem Analog-/Digitalwandler (22) und mit einem Entzerrer (3) mit einem digitalen Signalverarbeitungsteil (31, 32, 33, 34, 35) mit einer Register (331, 332, 333) aufweisenden Speichereinrichtung (33) zur Speicherung von Zustandsübergängen ($S_i$, $S_{i+1}$),
   <u>dadurch gekennzeichnet</u>,
   daß die Register (331, 332, 333) der Speichereinrichtung (33) jeweils $2^{n'}$ Speicherplätze aufweisen, mit $1 \leq n' < n$, daß die Speichereinrichtung (33) ein Gedächtnispfadregister (334) aufweist, in dem zu jedem diskreten Zeitpunkt (i) ab einem jeweils ersten zeitlich zurückliegenden Binärzeichen ($b_{i-1}$) für $2^{n'}$- Zustände mindestens n zeitlich zurückliegende Binärzeichen ($b_{i-1}, \ldots, b_{i-n'}, b_{i-n'-1}, \ldots, b_{i-n}, \ldots$) gespeichert werden.

2. Empfänger nach Anspruch 1,
   <u>dadurch gekennzeichnet</u>,
   daß der Entzerrer (3) eine Steuer- und Rechenlogik (35) aufweist, die aus den n'+1 diesen Zustandsübergang kennzeichnenden in der Speichereinrichtung (33) gespeicherten Binärzeichen ($b_i$, $\ldots b_{i-n'}$) und aus den n-n' Binärzeichen ($b_{i-n'-1}, \ldots, b_{i-n}$) des Gedächtnispfadregisters (334) Maßzahlen für einen Zustandsübergang ($S_i'$, $S_{i+1}'$) bildet, die aus der Bitfolge ($b_i$, $b_{i-1}, \ldots, b_{i-n'+1}$, $b_{i-n'}$) aller $2^{n'}$ möglichen Null- bzw. Eins-Pfade einen Null- bzw. Eins-Minimalpfad und zugeordnete Gesamtmaßzahlen bildet, die entscheidet, daß der Binärwert, der der kleinsten der beiden berücksichtigten Gesamtmaßzahlen zugeordnet ist, einen Schätzwert ($\hat{b}_{i-n'}$) für das Binärzeichen $b_{i-n'}$ ergibt und die aus den beiden berücksichtigten Gesamtmaßzahlen eine verlässigkeitsinformation ($P(\hat{b}_{i-n'})$) für diesen Schätzwert ($\hat{b}_{i-n'}$) bildet.

3. Empfänger nach Anspruch 1 oder 2,
   <u>dadurch gekennzeichnet</u>,
   daß das Gedächtnispfadregister (334) eine Speichertiefe von M zeitlich zurückliegenden Binärzeichen aufweist, mit $M \geq n$, daß dem Gedächtnispfadregister (334) zum Zeitpunkt i für das Binärzeichen

$b_{i-N}$ mit $n'<N\leq M$ ein Schätzwert ($\hat{b}_{i-N}$) dem Null-Minimalpfad entnommen wird, wenn die Gesamtmaßzahl des Null-Minimalpfades kleiner als die Gesamtmaßzahl des Eins-Minimalpfades ist, anderenfalls dem Eins-Minimalpfad, wobei durch Verzögerung der Zuverlässigkeitsinformation um N-n' Zeiteinheiten eine zeitrichtige Zuordnung des Schätzwertes ($\hat{b}_{i-N}$) zur Zuverlässigkeitsinformation des dem Binärzeichen ($b_{i-n'}$) zugeordneten Schätzwertes erfolgt.

4. Empfänger nach einem der Ansprüche 1 bis 3, <u>dadurch gekennzeichnet,</u> daß das Gedächtnispfadregister (334) eine Speichertiefe von M zeitlich zurückliegende Binärzeichen aufweist, mit $M\geq n$, daß zum Zeitpunkt i für ein Binärzeichen ($\hat{b}_{i-N}$), mit $n'<N\leq M$ eine Zuverlässigkeitsinformation ($P(\hat{b}_{i-N})$) gebildet wird und die Zuverlässigkeitsinformation ($P(\hat{b}_{i-N})$) durch einen vorgebbaren Ersatzwert ersetzt wird, wenn zum Zeitpunkt i entweder nur Nullpfade mit $b_{i-N} = 0$ oder nur Eins--Pfade mit $b_{i-N} = 1$ existieren.

5. Empfänger nach einem der Ansprüche 2 bis 4, <u>dadurch gekennzeichnet,</u> daß die Zuverlässigkeitsinformation durch das Verhältnis der den beiden ausgewählten Pfaden entsprechenden scheinlichkeitswerten gebildet wird.

6. Empfänger nach einem der Ansprüche 2 bis 5, <u>dadurch gekennzeichnet,</u> daß als Metrik einer Maßzahl die quadratische Distanz der Wahrscheinlichkeit des Überganges zwischen zwei Zuständen verwendet wird und zur Bildung der Gesamtmetrik einer Gesamtmaßzahl die ermittelte Metrik für einen Zustandsübergang zur bisherig ermittelten Gesamtmetrik addiert wird.

7. Empfänger nach einem der Ansprüche 2 bis 6, <u>dadurch gekennzeichnet,</u> daß die Gesamtmaßzahl des Null-Minimal-Pfades von der Gesamtmetrik des Eins-Minimal-Pfades subtrahiert wird und daß das Vorzeichen der Differenz den Schätzwert und der Absolutbetrag der Differenz die dem Schätzwert zugeordnete Zuverlässigkeitsinformation ergibt.

8. Empfänger nach einem der Ansprüche 2 bis 7, <u>dadurch gekennzeichnet,</u> daß die Zuverlässigkeitsinformation mit einer von einer ermittelten Störleistung abhängigen Größe berichtigt wird.

9. Empfänger nach einem der Ansprüche 1 bis 8, wobei zu übertragende Informationen (x) sendeseitig durch einen Faltungscoder (5) in die Binärzeichen (b) umcodiert werden, <u>dadurch gekennzeichnet,</u> daß dem Entzerrer (3) ein als Faltungsdecoder arbeitender Decodierer (6) nachgeschaltet ist, der bei der Decodierung neben den geschätzten Binärzeichen ($\hat{b}$) auch deren zugeordnete Zuverlässigkeitsinformation ($P(\hat{b})$) verarbeitet.

10. Digitales Übertragungssystem mit einem Empfänger nach einem der Ansprüche 1 bis 9.

**Claims**

1. A receiver for a digital transmission system (1, 2, 21, 22, 3) comprising a transmission channel (11) having a storage depth n, comprising an analog signal processing section (2, 21), an analog-to-digital converter (22) and an equalizer (3) which has a digital signal processing section (31, 32, 33, 34, 35) that includes a memory means (33) with a register (331, 332, 333) for storing state transitions ($S_i$, $S_{i+1}$), characterized in that the registers (331, 332, 333) of the memory means (33) all comprise $2^{n'}$ memory locations, with $1\leq n'<n$, in that the memory means (33) comprises a memory path register (334) in which at each discrete instant (i) at least n previous bits ($b_{i-1}$ $b_{i-n'}$, $b_{i-n'-1}$, ..., $b_{i-n}$ ...) are stored commencing at an appropriate first previous bit ($b_{i-1}$) for $2^{n'}$ states.

2. A receiver as claimed in Claim 1, characterized in that the equalizer (3) comprises a control and arithmetic logic (35) which forms probability parameters for a state transition ($S_{i'}$, $S_{i+1'}$) on the basis of the n'+1 bits ($b_i$, ... $b_{i-n'}$) featuring this state transition and stored in the memory means (33) and on the basis of the n-n' bits ($b_{i-n'-1}$, ..., $b_{i-n}$) of the memory path register (334), which control and arithmetic logic forms a minimum "0"-path and a minimum "1"-path respectively, on the basis of the bit sequences ($b_i$, $b_{i-1}$, ..., $b_{i-n'+1}$, $b_{i-n'}$) of all the $2^{n'}$ possible "0"-paths and "1"-paths and forms appropriate overall probability parameters, which control and arithmetic logic decides that the binary value assigned to the smaller of the two considered overall probability parameters is an estimate ($\hat{b}_{i-n}$) for the bit $b_{i-n'}$ and which control and arithmetic logic forms reliability information ($P(\hat{b}_{i-n'})$) for this estimate ($\hat{b}_{i-n'}$) on the basis of the two considered overall probability parameters.

3. A receiver as claimed in Claim 1 or 2, characterized in that the memory path register (334) has a storage depth of M previous bits, with $M\geq n$, in that at instant i an estimate ($b_{i-N}$) is taken from the minimum "0"-path of the memory path register (334) for the bit $b_{i-N}$ with $n'<N<M$ if the overall probability parameter of the minimum "0"-path is smaller than the overall probability parameter of the minimum "1"-path, otherwise from the minimum "1"-path, while a timely assignment of the estimate ($\hat{b}_{i-N}$) to the reliability information of the estimate assigned to the bit ($b_{i-n'}$) is obtained when delaying the reliability information by N-n' time intervals.

4. A receiver as claimed in one of the Claims 1 to 3, characterized in that the memory path register (334) has a storage depth of M previous bits, with M≥n, in that at instant i reliability information ($P(\hat{b}_{i-N})$) is formed for a bit ($b_{i-N}$) with n'< N ≤M and the reliability information ($P(\hat{b}_{i-N})$) is substituted by a predeterminable substitute value if either only "0"-paths with $b_{i-N} = 0$ or only "1"-paths with $b_{i-N} = 1$ exist at instant i.

5. A receiver as claimed in one of the Claims 2 to 4, characterized in that the reliability information is formed by the ratio between the probability values of the two selected paths.

6. A receiver as claimed in one of the Claims 2 to 5, characterized in that the squared distance of the probability of the transition between two states is used as a metric of a probability parameter and the metric formed for a state transition is added to the overall metric determined so far to form the overall metric of an overall probability parameter.

7. A receiver as claimed in one of the Claims 2 to 6, characterized in that the overall metric of the minimum "0" -path is subtracted from the overall metric of the minimum "1"-path and in that the sign of the difference denotes the estimate and the absolute difference value denotes the reliability information assigned to the estimate.

8. A receiver as claimed in one of the Claims 2 to 7, characterized in that the reliability information is corrected by a value depending on a given noise power.

9. A receiver as claimed in one of the Claims 1 to 8, in which information signals (x) to be transmitted are encoded into the bits (b) by means of a convolution encoder (5) at the transmitter end, characterized in that a decoder (6) operating as a convolution decoder is arranged after the equalizer (3) in this system, which decoder, when decoding, processes not only the estimated bits ($\hat{b}$) but also the reliability information ($P(\hat{b})$) assigned to these bits.

10. A digital transmission system comprising a receiver as claimed in one of the Claims 1 to 9.

## Revendications

1. Récepteur pour un système de transmission numérique (1,2,21,22,3) avec un canal de transmission (11) avec une profondeur mnémonique n, avec une partie analogique de traitement des signaux (2, 21), avec un convertisseur analogique/numérique (22) et avec un redresseur (3) avec une partie numérique de traitement des signaux (31, 32, 33, 34, 35) avec un dispositif de mémoire (33) présentant un registre (331, 332, 333) pour la sauvegarde de transitions d'états ($S_i$, $S_{i+1}$),

caractérisé en ce

que les registres (331, 332, 333) du dispositif de mémoire (33) présentent respectivement $2^{n'}$ emplacements de mémoire, avec 1≤n'≤n, que le dispositif de mémoire (33) présente un registre de voies mnémoniques (334) dans lequel sont sauvés au moins n signes binaires en aval temporellement ($b_{i-1},...,b_{i-n'},b_{i-n'-1},...,b_{i-n},...$) à chaque moment discret (i) à partir d'un premier signe binaire ($b_{i-1}$) en aval temporellement pour $2^{n'}$ états.

2. Récepteur selon la revendication 1,

caractérisé en ce

que le redresseur (3) présente une logique de commande et de calcul (35) qui forme à partir des n'+1 signes binaires ($b_i,...,b_{i-n'}$) sauvés dans le dispositif de mémoire (33) et caractérisant cette transition d'état et à partir des n-n' signes binaires ($b_{i-n'-1},...,b_{i-n}$) du registre des voies mnémoniques (334) des mesures pour une transition d'état ($S_i'$, $S_{i+1}'$) qui forme à partir de la séquence binaire ($b_i$, $b_{i-1},...,b_{i-n'+1}$, $b_{i-n'}$) de toutes les $2^{n'}$ voies zéro ou voies un possibles une voie minimale zéro ou un et des mesures globales affectées, qui décide que la valeur binaire qui est affectée à la plus petite des deux mesures globales considérées donne une valeur d'estimation ($\hat{b}_{i-n'}$) pour le signe binaire $b_{i-n}$ et qui forme à partir des deux mesures globales considérées une information de fiabilité ($P(\hat{b}_{i-n'})$) pour cette valeur d'estimation ($\hat{b}_{i-n'}$).

3. Récepteur selon la revendication 1 ou 2,

caractérisé en ce

que le registre de voies mnémoniques (334) présente une profondeur de mémoire de M signes binaires en aval temporellement avec M ≥ n, que, du registre des voies mnémoniques (334), une valeur d'estimation ($b_{i-N}$) est prélevée de la voie minimale zéro pour le signe binaire $b_{i-N}$ avec n'< N ≤ M lorsque la mesure globale de la voie minimale zéro est inférieure à la mesure globale de la voie minimale un ou,. dans le cas contraire, de la voie minimale un, une affectation en temps utile de la valeur d'estimation ($\hat{b}_{i-N}$) étant assurée pour l'information de fiabilité de la valeur d'estimation affectée au signe binaire ($b_{i-n'}$) par le retard de l'information de fiabilité de N-n' unités de temps.

4. Récepteur selon l'une des revendications 1 à 3, caractérisé en ce que le registre de voies mnémoniques (334) présente une profondeur de mémoire de M signes binaires en aval temporellement, avec $M \geq n$, qu'au moment i, une information de fiabilité ($P(\hat{b}_{i-N})$) est formée pour un signe binaire ($\hat{b}_{i-N}$) avec $n' \leq N \leq M$ et l'information de fiabilité ($P(\hat{b}_{i-N})$) est remplacée par une valeur de remplacement à prédéfinir lorsqu'au moment i, il existe soit seulement les voies zéro avec $b_{i-N}=0$ ou les voies un avec $b_{i-N}=1$.

5. Récepteur selon l'une des revendications 2 à 4, caractérisé en ce que l'information de fiabilité est formée par le rapport entre les valeurs de probabilité correspondant aux deux voies sélectionnées.

6. Récepteur selon l'une des revendications 2 à 5, caractérisé en ce que la distance carrée de la probabilité de la transition entre deux états est utilisée comme métrique d'une mesure et la métrique déterminée pour une transition d'état est additionnée à la métrique globale obtenue jusqu'à présent pour la formation de la métrique globale d'une mesure globale.

7. Récepteur selon l'une des revendications 2 à 6, caractérisé en ce que la mesure globale de la voie minimale zéro est soustraite de la métrique globale de la voie minimale un et que le signe de la différence donne la valeur d'estimation et la valeur absolue de la différence l'information de fiabilité affectée à la valeur d'estimation.

8. Récepteur selon l'une des revendications 2 à 7, caractérisé en ce que l'information de fiabilité est annoncée avec une grandeur dépendant d'une puissance perturbatrice déterminée.

9. Récepteur selon l'une des revendications 1 à 8, les informations (x) à transmettre étant codées côté émetteur par un codeur de convolution (5) en signes binaires (b), caractérisé en ce qu'un décodeur (6) travaillant comme décodeur de convolution est monté en aval du redresseur (3) et traite lors du décodage, outre les signes binaires estimés ($\hat{b}$), l'information de fiabilité ($P(\hat{b})$) qui leur est affectée.

10. Système de transmission numérique avec un récepteur selon l'une des revendications 1 à 9.

FIG.1

FIG.2

FIG.6

**F IG.3**

**F IG.4**

**F IG.5**